# EUROPÄISCHE PATENTSCHRIFT

(11) **EP 0 388 485 B1**
(45) Veröffentlichungstag und Bekanntmachung des Hinweises auf die Patenterteilung: **05.10.1994**
(21) Anmeldenummer: 89104951.2
(22) Anmeldetag: 20.03.1989
(51) Int. Cl.: G01R 31/26, G01R 31/28

(54) **Messfassung für Mikrowellenbauelemente**
Test fixture for microwave circuits
Dispositif de support pour tester des circuits à micro-ondes

(43) Veröffentlichungstag der Anmeldung: 26.09.1990
(73) Patentinhaber: SIEMENS AKTIENGESELLSCHAFT, 80333 München (DE)
(72) Erfinder: Zimmermann, Walter, D-8250 Dorfen 1 (DE)

(56) Entgegenhaltungen:
- DE-U- 8 810 268
- US-A- 4 340 860
- US-A- 4 707 656
- PROCEEDINGS 15th EUROPEAN MICROWAVE CONFERENCE, Paris, 9th - 13th September1985, pages 465-470, Microwave Exhibitions and Publishers Ltd, Tunbridge Wells,Kent, GB; J.J.M. KWASPEN: "A coaxial test fixture for microwave transistorcharacterisation"

## Beschreibung

Die Erfindung betrifft eine Mikrowellen-Bauelemente-Meßfassung nach dem Oberbegriff des Anspruchs 1.

Eine derartige Meßfassung geht aus der US-PS 4.707.656 als bekannt hervor. Weiterhin ist aus der US-PS 4.340.860 bekannt, bei einer Meßfassung für Integrierte Schaltungen in einem dort vorgesehenen Meßkopf ein elastisches Teil zu verwenden, das die für den Meßkopf erforderlichen elastischen Eigenschaften bewirkt.

Die Messung der Mikrowelleneigenschaften von Mikrowellen-Bauelementen erfordert eine Vorrichtung, mit der mit hoher Meßgenauigkeit auch bei hohen Frequenzen präzise Meßergebnisse erzielt werden können.

Insbesondere die serienmäßige Messung der Mikrowelleneigenschaften von Mikrowellenhalbleitern erfordert eine Vorrichtung zum präzisen Messen dieser Mikrowelleneigenschaften.

Auch wegen der Umstellung von Mikrowellen-Halbleitergehäusen auf automatenbestückbare Bauformen, insbesondere auf SMD-Bauformen, beispielsweise mit gekürzten Anschlußbändchen oder auch völlig ohne Anschlußbändchen (direkt-kontaktierbare Mikrowellen Gehäuse) ist ein Gerät zur präzisen Messung der Mikrowelleneigenschaften erforderlich.

Eine Meßfassung zur Messung der Mikrowelleneigenschaften von Mikrowellen-Bauelementen mit verschiedenen Gehäusebauformen soll sowohl den Präzisions- als auch den Produktionsanforderungen gerecht werden.

Bekannte Meßfassungen in Mikrostreifenleitertechnik besitzen den Nachteil parasitärer Effekte mit erheblichen Auswirkungen auf die Meßgenauigkeit. Sonst sind keine Meßfassungen bekannt, welche in der Lage sind, Mikrowellen-Bauelemente mit gekürzten Anschlußbändchen zu bewerten.

Der vorliegenden Erfindung liegt die Aufgabe zugrunde, eine Meßfassung der eingangs genannten Art anzugeben, welche auch für die Messung von automatenbestückbaren Mikrowellen-Bauelementen hohen Präzisisonsanforderungen bezüglich der Meßergebnisse gerecht wird.

Diese Aufgabe wird erfindungsgemäß durch eine Meßfassung nach dem Anspruch 1 gelöst.

Ausgestaltungen und Vorteile der Erfindung sind in den abhängigen Ansprüchen, der Beschreibung und der Zeichnung angegeben.

Die Erfindung ermöglicht eine Miniatur-Meßfassung, in welcher das Bauelement über ein Schiebersystem in die Meßfassung eingeführt, positioniert und direkt an die Innenleiter von Steckern kontaktiert wird. Die elektrische Güte dieser Meßfassung wird fast ausschließlich durch die Güte der Stecker bestimmt (limitiert).

Eine Meßfassung nach der Erfindung ist elektrisch sehr genau, verlustarm, extrem reproduzierbar. Eine Meßfassung nach der Erfindung ist sehr anwenderfreundlich, robust und verschleißfest.

Eine Meßfassung nach der Erfindung besitzt überragende Eigenschaften bezüglich der Präzision der Meßergebnisse.

Eine Meßfassung nach der Erfindung zeichnet sich aus durch einfache Bedienbarkeit, hohe Kontaktiersicherheit, hohe Standfestigkeit, geringen Wartungsaufwand sowie durch seine hohe Präzision und seine extrem gute Meßreproduzierbarkeit auch bei Frequenzen höher als 20 GHz. Mit einer Meßfassung nach der Erfindung ist es möglich, eine maximale Phasenabweichung von weniger als zwei Grad bei einer Frequenz von 18 GHz zu erzielen.

Eine Meßfassung nach der Erfindung ist mechanisch sehr einfach aufgebaut und an verschiedene Gehäusebauformen optimal anpaßbar.

Eine Meßfassung nach der Erfindung ist beispielsweise für ein Bauelement-Gehäuse vom Typ CEREC 100 mil geeignet. Eine Meßfassung nach der Erfindung ist ebenfalls für die Gehäuse-Bauformen vom Typ H-Pac 100, CEREC 70 und H-Pac 70 geeignet.

Die Bedienung und die Wartung der Meßfassung ist sehr einfach: Das zu messende Bauteil kann in die Aussparung eines Schiebers eingelegt und in die Meßfassung eingeschoben werden. Positionierung und Kontaktierung des zu messenden Bauteils in der Meßfassung erfolgen automatisch. Eine mechanische Überlastung der Meßfassung ist ausgeschlossen.

Der Bestückungsvorgang der Meßfassung mit zu messenden Bauteilen kann rationalisiert werden, beispielsweise durch Preßluftbetrieb und ferner mit Hilfe einer magazinierten Technik. Es können mehrere zu messende Bauteile in die Schiebeeinrichtung aufgenommen werden. Es können auch mehrere verschiedene Schieber hintereinander mit verschiedenen zu messenden Bauteilen in die Meßfassung eingebracht werden. Eine Bestückung der Meßfassung mit zu messenden Bauteilen kann automatisiert werden.

Eine Rationalisierung des Betriebs einer Meßfassung nach der Erfindung kann in jeder Weise erfolgen, die einem Fachmann zur Verfügung steht.

Mit einer Meßfassung nach der Erfindung können sämtliche Mikrowellen-Bauelemente oder auch sonstige Bauelemente bei niedrigeren Frequenzen gemessen werden, für deren Messung ein Fachmann eine Meßfassung nach der Erfindung zu verwenden in der Lage ist.

Eine Meßfassung nach der Erfindung kann so ausgestaltet werden, daß sie gegen Kontaktverschmutzungen relativ unempfindlich ist. Z.B. kann eine Meßfassung selbstreinigend ausgebildet werden, wenn bei einer Betätigung eines Schiebers Verschmutzungen aus der Meßfassung herausgenommen werden.

Aufgrund der sehr geringen Verluste ermöglicht eine Meßfassung nach der Erfindung ein sehr vereinfachtes Meßplatz-Calibrier-Verfahren beispielsweise bei 6 GHz, wobei unabhängig von bestimmten Transistor-Chargen mit einer Festkorrektur mit einem Fehler von weniger als 0,1 dB gearbeitet werden kann. Eine solche Meßfassung besitzt besonders geringe Verluste in Verbindung mit Slide-screw-Tunern.

Eine Meßfassung nach der Erfindung ermöglicht es, daß zur Meßplatz-Calibrierung die Noise-Source nicht mehr umgesetzt werden muß. Damit ergibt sich pro zu messender Transistor-Halbleiterscheibe eine Zeiteinsparung von etwa 10 Minuten. Die früher für eine zu messende Transistor-Halbleiterscheibe notwendige Einrichterarbeit entfällt bei einer Meßfassung nach der Erfindung. Ferner sinkt der Stecker-Verschleiß erheblich.

Eine Meßfassung nach der Erfindung ist auch für Halbleiter-Bauelemente mit langen Anschluß-Bändchen, beispielsweise für Transistoren möglich.

Eine Meßfassung nach der Erfindung findet vorteilhafterweise Verwendung für Mikrowellen-Tetroden vom Typ CFY 20/21 mit beschnittenen Anschluß-Bändchen.

Eine Meßfassung nach der Erfindung liefert genaueste Ergebnisse, ohne daß ein Meßfehler (de-embedding) korrigiert werden würde. Bei einer Meßfassung nach der Erfindung sind die Meßfehler so gering, daß diese Meßfehler vernachlässigt werden können.

Eine Meßfassung nach der Erfindung ist serientauglich, ermöglicht eine Präzisionsmeßfassung mit hoher Grundgenauigkeit und hoher Reproduziergenauigkeit. Die Grundgenauigkeit ist um eine bis zwei Größenordnungen besser als bei bekannten Meßfassungen.

Die zu messenden Bauteile in der Meßfassung können mit Hilfe von Steckern oder mit Hilfe von Leitungen kontaktiert werden.

Eine Meßfassung nach der Erfindung ermöglicht auch deshalb eine hohe Kontaktsicherheit, weil bei Verwendung eines Schiebers Schmutz immer wieder aus der Meßfassung herausgeschoben werden kann.

Eine Meßfassung nach der Erfindung ermöglicht die Verwendung von unterschiedlichen Meßeinsätzen für unterschiedliche zu messende Bauteile.

Die Erfindung wird im folgenden anhand eines Ausführungsbeispiels näher erläutert.
- FIG 1 und 2: erläutern schematisch eine Meßfassung nach der Erfindung.
- FIG 3 bis 15: zeigen Einzelheiten einer Meßfassung nach der Erfindung.

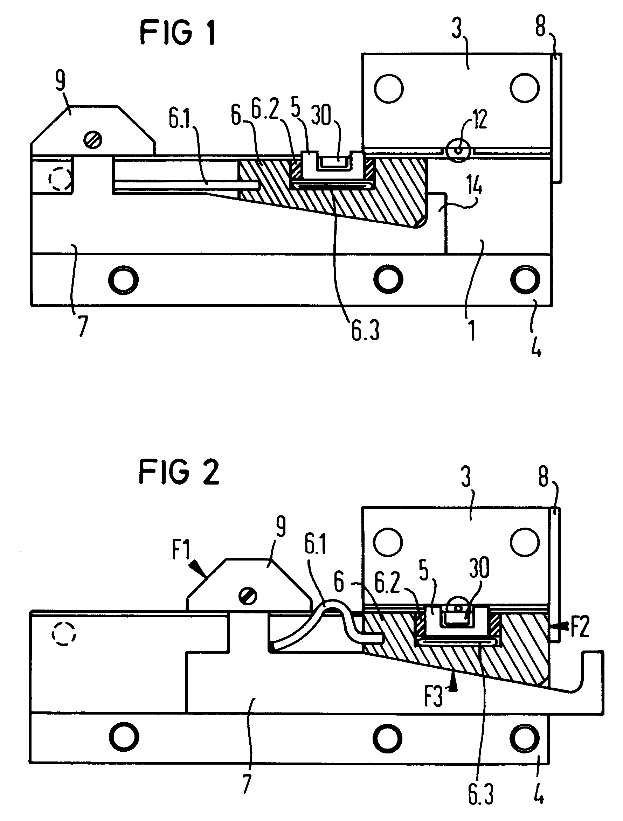

FIG 1 und 2 erläutern schematisch den Aufbau und die Funktion eines Ausführungsbeispieles für eine Meßfassung nach der Erfindung. Eine solche Fassung umfaßt einen Führungskörper für die Schiebe-Einrichtung. Als Führungskörper können zwei Seitenteile 1, 2 dienen. Zur Kontaktierung des zu messenden Bauteils sind Leitungen 12 vorhanden. Solche Leitungen 12 können aus der Meßfassung herausführen. Solche Leitungen 12 können als semi-rigid-Leitungen ausgebildet sein. Solche Leitungen 12 können jedoch auch Innenleiter von zwei Steckern sein, die mit der Meßfassung fest verbunden sind. Im Inneren der Meßfassung liegen ein Massesteg 3 und eine Schiene 4, die den Innenraum der Meßfassung und die Breite des Schiebesystems bestimmen. Massesteg 3 und Schiene 4 können zwischen den Seitenteilen 1, 2 befestigt sein.

Die Schiebeeinrichtung weist einen Schlitten 6 auf. Dieser Schlitten 6 kann als Keil-Schlitten ausgebildet sein. Die Schiebe-Einrichtung weist einen Schieber 7 auf, der mit Hilfe eines Griffs 9 im Führungskörper in einer räumlichen Dimension hin und herbewegt werden kann. Mit Hilfe einer solchen räumlich eindimensionalen Bewegung des Schiebers 7 wird der Keil-Schlitten 6 sowohl in derselben Richtung, in der sich der Schieber 7 bewegt, hin- und herbewegt als auch in einer Richtung, die von der Richtung dieser eindimensionalen Bewegung des Schiebers 7 verschieden ist, zur Kontaktierung eines zu messenden Bauteils 30 in der Meßfassung gegen den Massesteg 3 gedrückt. Diese zweite Richtung, die verschieden von der Richtung der eindimensionalen Bewegung des Schiebers 7 ist, kann senkrecht zur Richtung dieser eindimensionalen Bewegung des Schiebers 7 sein, kann jedoch auch einen anderen Winkel verschieden von 90° mit dieser Richtung der Bewegung des Schiebers 7 aufweisen.

Die Schiebeeinrichtung ist im Ausführungsbeispiel eine Keil-Schiebeeinrichtung mit den Teilen 5, 6, 7, 8 und 9. Das Keil-Schiebesystem nimmt in einer Aufnahme 5 das zu messende Bauteil 30 auf, führt das zu messende Bauteil 30 in die Meßfassung ein, positioniert das zu messende Bauteil 30 mittels eines Anschlags 8 und kontaktiert das zu messende Bauteil 30 mit Hilfe des Keile-Schlittens 6 und mit Hilfe des Schiebers 7 vertikal gegen die Innenleiter 12 von zwei Steckern und gegen den Massesteg 3. Das zu messende Bauteil 30 ist mit dem Kopf nach unten in der Aufnahme 5 in einer Ausnehmung des Keil-Schlittens 6 angeordnet. Zwischen der Aufnahme 5 und dem Keilschlitten 6 befindet sich ein Polster 6.3. Die Elastizität dieses Polsters 6.3 in vertikaler Richtung sorgt für eine sichere Massekontaktierung des zu messenden Bauteils 30. Ist das zu messende Bauteil 30 ein Mikrowellen-Transistor, so sorgt das Polster 6.3 für eine sichere Massekontaktierung der beiden Source Anschlüsse über die Aufnahme 5 an den Massesteg 3. Die Elastizität des Polsters 6.3 in seitlicher Richtung, also in einer Richtung, welche in einer Ebene liegt, die aufgespannt wird durch die Richtung der eindimensionalen Bewegung des Schiebers 7 und durch eine Richtung senkrecht zum Zeichnungsblatt, sorgt für einen unmittelbaren Massekontakt der Aufnahme 5 an den beiden Seitenteilen (Wangen) 1, 2, wodurch parasitäre Resonanzen der Aufnahme 5 und der übrigen Teile der Schiebe-Einrichtung sicher unterbunden werden.

Je sorgfältiger das Polster 6.3 hergestellt und eingepaßt wird, desto besser sind die erzielten Meßergebnisse. Das Polster 6.3 kann so ausgebildet werden, daß es die Bewegung des Schlittens 6 nicht hemmt. Eine Feder 6.1 zwischen Schieber 7 und Keile-Schlitten verhindert zusätzlich eine unerwünschte Hemmung des Schlittens 6 beim Einführen der Schiebe-Einrichtung in die Meßfassung, wobei gleichzeitig die volle vertikale Bewegungsfreiheit des Schlittens 6 gewährleistet ist. Dadurch wird ermöglicht, daß nach Lösen des Schiebers 6 aus der Kontaktierposition des zu messenden Bauteils 30 in der Meßfassung dieser Schieber wieder nach unten (vom Massesteg 3 weg) fallen kann.

Je planer die einzelnen Komponenten der Meßfassung hergestellt sind, desto besser sind die Meßergebnisse. Die einzelnen Teile der Meßfassung können gegebenenfalls durch ein sogenanntes Abziehen eingepaßt werden.

Die Bohrung für die Leitungen 12 in den Seitenteilen 1, 2 sollen beim Entgraten keine Phase erhalten.

Beim Zusammenbau der Meßfassung ist äußerste Reinheit vorteilhaft für besonders gute Meßergebnisse.

Zur sicheren Kontaktierung des zu messenden Bauteils 30 an den Unterseiten der elektrischen Leitungen 12 kann der Massesteg 3 derart justiert werden, daß die Anschlußkontakte des zu messenden Bauteils 30 auf die Leiter 12 einen gewissen Druck ausüben, der die elektrischen Kontakte des zu messenden Bauteils 30 etwas federn läßt.

Der Massesteg 3 kann folgendermaßen justiert werden:
Zuerst werden die mechanischen Verbindungen, mit denen die beiden Seitenteile 1, 2 verbunden sind, leicht gelöst. Dabei sollte der Massesteg 3 zwischen den beiden Seitenteilen 1, 2 gut schleifend beweglich sein. Sodann wird der Massesteg 3 nach unten gedrückt. Danach wird ein zu messendes Bauteil 30 in die Aufnahme 5 eingelegt. Dann wird der Schieber 7 in die zur Kontaktierung des zu messenden Bauteils 30 vorgesehene Position geführt. Dabei bewegt sich der Massesteg 3 nach oben (vom Keilschlitten 6 weg).

Bei einem fühlbaren Druck, bei dem das zu messende Bauteil 30 an die elektrischen Leiter 12 kontaktiert, werden die mechanischen Verbindungen, mit denen die Seitenteile 1, 2 befestigt werden, fixiert. Die Kontakte des zu messenden Bauteils 30 werden geprüft. Diese Kontakte des zu messenden Bauteils 30 dürfen bei einem richtig justierten Massesteg 3 nicht beschädigt sein. Schließlich ist noch zu prüfen, ob eine sichere Kontaktgabe vorliegt. Damit ist der Justiervorgang der Meßfassung beendet.

Der Massesteg 3 könnte auch mit Hilfe von Madenschrauben in der Meßfassung justiert werden.

Zum sicheren Herausführen des zu messenden Bauteils 30 aus der Meßfassung besitzt der Schieber 7 einen Anschlag 14 zum Lösen und Abtransport des Keileschlittens 6 aus der Kontaktierposition.

In FIG 1 ist die Meßfassung zur Bestückung mit dem zu messenden Bauteil 30 geöffnet. In den FIG 1 und 2 ist das beim Betrachten der Meßfassung vordere Seitenteil 2 abgenommen. In FIG 2 ist die Meßfassung zur Messung des Bauteils 30 geschlossen. Dabei wird das zu messende Bauteil 30 mit Hilfe des Schiebers 7 mit der Kraft F1 über den Griff 9 in die Meßfassung hineinbewegt, bis das zu messende Bauteil 30 durch den Anschlag des Keiles 6 an der Anschlagplatte 8 horizontal positioniert ist und durch die Kraftumlenkung von der Kraft F2, welche vom Anschlag 8 auf den Keil ausgeübt wird, in die Kraft F3, die von dem Schieber 7 mittels eines geneigten Randes des Schiebers 7 von unten her auf den Keil 6 ausgeübt wird, vertikal nach oben kontaktiert wird. Dabei ergibt sich durch Kraftschluß zwischen der Aufnahme 5 und dem Massesteg 3 ein Massekontakt. Die Signalwege sind dabei durch den Andruck des zu messenden Bauteils 30 an die Leiter 12 und möglicherweise über angeflanschte Stecker nach außen hergestellt. Die exakte Einstellung der Kontaktierposition des zu messenden Bauteils 30 erfolgt durch eine vertikale Justage des Massestegs 3. Die Meßfassung verbleibt selbsthemmend in der Kontaktierposition.

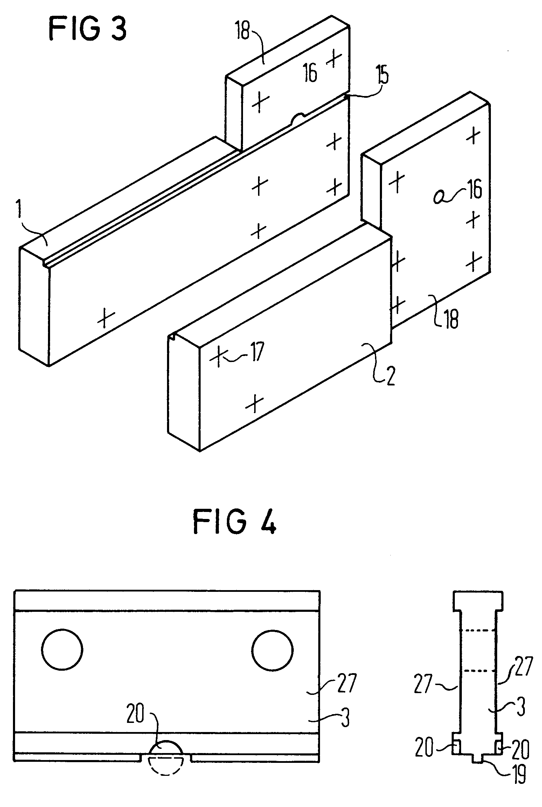

FIG 3 bis 15 erläutern weitere Einzelheiten einer Meßfassung nach der Erfindung.

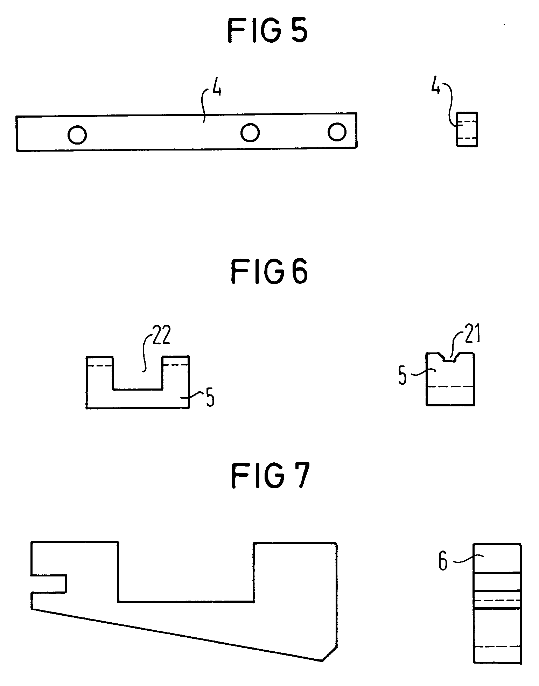

Sämtliche nicht-elastischen Teile der Meßfassung können aus Messing mit einer 5 Mikrometer dicken Oberflächenvergoldung hergestellt werden. Die beiden Seitenteile 1, 2 besitzen beide eine gesägte Nut 15, um eine Bewegung von Anschlußbändchen eines zu messenden Bauteils 30 innerhalb der Meßfassung mit Hilfe einer Schiebe-Einrichtung nicht zu hemmen. Außerdem wird dadurch die Masse-Kontaktierung verbessert. Die beiden Seitenteile 1, 2 werden an ihrer Unterseite mit Hilfe von drei Schrauben mit der Schiene 4 von FIG 5 als Zwischenstück aneinander befestigt. Außerdem dient noch eine Bohrung 17 in den Seitenteilen 1, 2 zur Befestigung der Seitenteile 1, 2 zueinander und auch zur Begrenzung des Weges des Schiebers 7 in der Richtung vom Massesteg 3 weg. In den Bereichen 18, wo das Anflanschen von zwei Steckern von außen her vorgesehen ist, sind die Seitenteile 1, 2 auf eine geringere Dicke gefräst. Die Innenflächen der Seitenteile 1, 2 sind plan abgezogen. Die Bohrungen 16 dienen zur Aufnahme von Innenleitern 12 der Stecker. Die Stecker können von außen her an die Seitenteile 1, 2 mit vier Schrauben angeflanscht werden.

FIG 4 zeigt einen Massesteg 3. Der Massesteg 3 weist nach unten zum zu messenden Bauteil 30 hin einen Steg 19 auf. Dieser Steg 19 dient zur Masse-Kontaktierung des zu messenden Bauteils 30. Außerdem weist der Massesteg 3 auf beiden Seiten zu den beiden Seitenteilen 1, 2 hin auf Höhe der Bohrungen 16 in den Seitenteilen 1, 2 jeweils eine halbkugelförmige Ausfräsung 20 auf, in welche die Enden der Leitungen 12 hineinragen können. Außerdem sind sämtliche Fräsungen, Nuten, Stege und verringerte Dicken in den Bereichen 18 günstig für verbesserte Meßergebnisse.

FIG 6 zeigt eine Aufnahme 5. Die Aufnahme 5 besitzt Vertiefungen 21, 22. Die Vertiefung 21 korrespondiert zum Steg 19 des Massestegs 3. Die Vertiefung 23 korrespondiert zu den Bohrungen 16 und zur Ausfräsung 20. Eine Aufnahme 5 kann auch so ausgestaltet sein, daß sie mehrere zu messende Bauteile 30 gleichzeitig aufnehmen kann. Eine Aufnahme 5 kann im Rahmen einer Schiebe-Einrichtung auch so ausgestaltet sein, daß beispielsweise nach dem Messen eines Bauteils 30 der Anschlag 8 sich zur Seite bewegt, bis ein neues zu messendes Bauteile 30 in Kontaktierposition gebracht werden soll, und daß auf diese Weise sukzessive durch eine Bewegung der Schiebe-Einrichtung in immer nur eine einzige Richtung ein Bautteil 30 nach dem anderen gemessen werden kann. Dabei können auch gleichzeitig mehrere Bauteile gruppenweise sukzessive hintereinander gemessen werden. Beispielsweise kann eine Schiebe-Einrichtung für einen solchen Zweck sich gurtförmig oder bandförmig oder kreisförmig in immer einer Richtung durch eine Meßfassung hindurch fortbewegen.

Die Aufnahmen 5 oder auch die Schieber 6 können unterschiedlich für unterschiedliche Bauteile 30 dimensioniert sein. Die Abmessungen der Einzelheiten 19, 20, 21 können an unterschiedliche Abmessungen der elektrischen Kontakte der Bauteile 30 angepaßt werden. Durch unterschiedlich große Aufnahmen für die Bauteile 30 können die Bauteile mit unterschiedlichen Abmessungen aufgenommen werden. Grundsätzlich können auch Bauteile mit mehr als 4 Anschlüssen gemessen werden.

FIG 7 zeigt einen Schlitten 6.

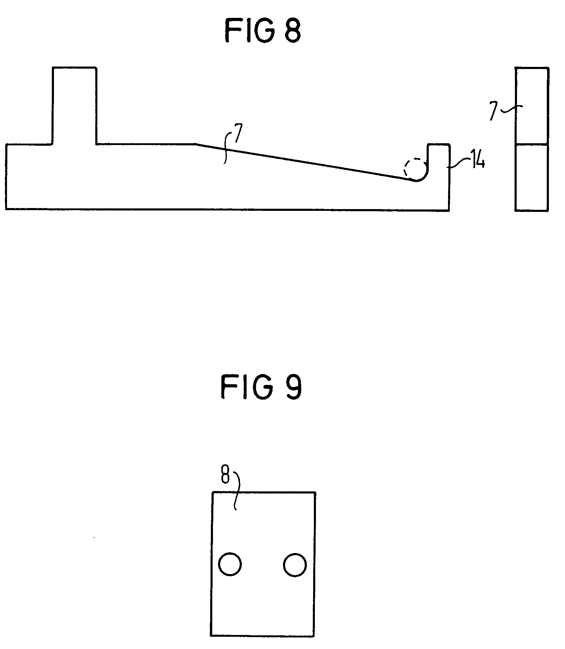

FIG 8 zeigt einen Schieber 7.

FIG 9 zeigt eine Anschlag-Platte 8.

Das Polster 6.3 ermöglicht eine mechanische Federung der Aufnahme 5, um den Masseandruck beim zu messenden Bauteil 30 zu garantieren. Das Polster 6.3 dient außerdem zur elektrischen Masseverbindung zwischen der Aufnahme 5 und den beiden Seitenteilen 1, 2 bei geschlossener Meßfassung zur Vermeidung parasitärer Resonanzen der Aufnahme 5.

Das Polster 6.3 federt in vertikaler Richtung. Das Polster 6.3 kann bei vertikalem Druck eine seitliche Ausdehnung zur Masseverbindung mit den Seitenteilen 1, 2 erleiden. Bei vertikaler Druckentlastung übt das Polster 6.3 keinen seitlichen Druck aus.

Das Massepolster 6.3 kann aus einem Silikongummiband bestehen und die Form eines Plättchens besitzen, wobei es von einer Kupfer-Schlauch-Litze umgeben sein kann. Das Polster 6.3 kann auch aus einem Kupfer-Gewebeband bestehen, das mehrfach gefaltet ist.

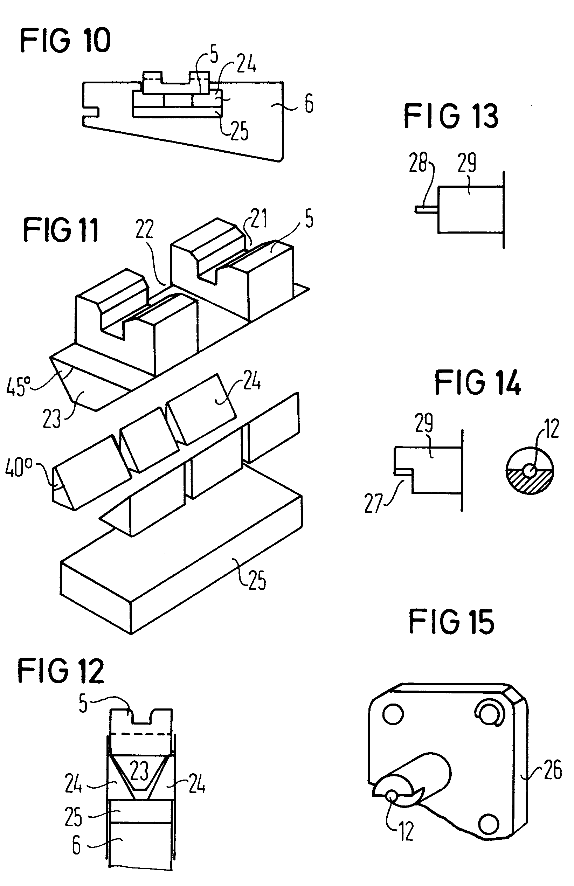

FIG 10 bis 12 erläutern eine besonders vorteilhafte Ausführung für die Aufnahme 5. Die Aufnahme 5 besitzt dabei wiederum Ausnehmungen 21, 22, wie anhand von FIG 6 erläutert. Außerdem besitzt die Aufnahme 5 ein keilförmiges Unterteil 23. In die für die Aufnahme des zu messenden Bauteils 30 vorgesehene Ausnehmung des Schiebekeils 6 wird zunächst ein Plättchen 25 aus Silikongummi eingelegt. Auf dieses Plättchen 25 werden sechs Metallkeile 24 so aufgelegt, daß das keilförmige Unterteil 23 der Aufnahme 5 in diesen Keilen 24 gelagert werden kann. Die Keile 24 bestehen vorteilhafterweise aus Metall. An der Seite eines jeden Seitenteils 1, 2 sind jeweils drei Keile hintereinander in Längsrichtung angeordnet. Die Keile 24 sind Zylinder mit einem Dreieck als Grundform. Auch die Aufnahme 5 besteht vorteilhafterweise aus einem Metall. Die Metallkeile 24 sind so geformt, daß eine Kontaktgabe zwischen der Aufnahme und den Keilen 24 unmittelbar unter dem zu messenden Bauteil 30, das in die Aufnahme 5 eingelegt ist, erfolgt. Zu diesem Zweck können die Metallkeile mit ansonsten beliebigen geometrischen Formen so ausgebildet sein, daß eine Kontaktgabe unmittelbar unter dem zu messenden Bauteil 30 erfolgt. Zu diesem Zweck können die Metallkeile 24 einen spitzeren Winkel als das keilförmige Unterteil 23 der Aufnahme 5 aufweisen. Beispielsweise können die Keile 24 an dem Ende, das zum zu messenden Bauteil 30 hinweist, einen Winkel von 40° besitzen. Wenn dann das keilförmige Unterteil 23 der Aufnahme 5 an dem zu messenden Bauteil 30 benachbarten Ende einen Winkel von 45 ° aufweist, ist das Auftreten von parasitären Effekten praktisch ausgeschlossen. Die Verwendung von sechs Keilen 24 schaltet unerwünschte Eigenschwingungen aus.

Auch die Verwendung von nur einem Keil 24 auf jeder Seite der Aufnahme 5 in Verbindung mit Distanzstücken ist möglich.

FIG 13 bis 15 erläutern die Verwendung von Steckern. Als Stecker sind besonders gut geeignet Stecker APC 7, PC 7 der Firma Rosenberger, D-8261 Tittmoning (DE). Die Eignung einer Meßfassung nach der Erfindung wird im wesentlichen durch die Ausbildung einer Hohlraumwelle in den Steckern begrenzt. Wenn also Stecker für sehr hohe Frequenzen geeignet sind, dann ist auch eine Meßfassung nach der Erfindung für sehr hohe Frequenzen geeignet.

Die inneren Kontakte 12 der Stecker sind so ausgebildet, daß sie mit 0,1 mm Federweg im Teflon federn. Eine gewisse Extentrizität beim Stecker ist nicht schädlich für die Präzision einer Messung. Der Federweg bei einem Innenleiter 12 verringert die Notwendigkeit für ein präzises Justieren der Meßfassung.

FIG 13 zeigt die Anschlußseite eines Steckers wie er im Handel zum Kauf angeboten wird. Für eine Meßfassung nach der Erfindung wird zunächst der Stift 28 abgetrennt. Sodann wird von der Dielektrikumhülse 29, die um den Stift 28 herum angeordnet ist, ein Halbkreissegment 27 gemäß FIG 14 abgetrennt. FIG 15 zeigt schließlich einen Flansch 26, der im Bereich 18 der Seitenteile 1, 2 von außen her angeflanscht wird, wobei der Innenleiter 12 des Steckers durch die Bohrung 16 in das Innere der Meßfassung hineinragt.

Bei einer Meßfassung nach der Erfindung wird das zu messende Bauteil 30 nicht geschädigt, unabhängig vom Druck F1, mit dem die Meßfassung geschlossen wird und unabhängig vom Druck F3, mit dem das zu messende Bauteil 30 gegen den Massesteg 3 gedrückt wird. Ein optimales Gleiten bei der Schiebe-Einrichtung wird durch Rhodinieren der Gleitflächen erzielt.

Bezugsebene für die Kontaktier-Positionierung ist bei einer Meßfassung nach der Erfindung immer der Massesteg 3, auch für die Stecker. Daher wird ein elektrischer Anschluß-Kontakt unabhängig von der Dicke, beispielsweise eines Anschluß-Bändchens, immer in der richtigen Weise nach oben gedrückt.

Eine Meßfassung nach der Erfindung hat eine hohe Standfestigkeit und besitzt praktisch keinen Verschleiß.

Der Massesteg 3 kann vorteilhafterweise oberhalb der Ausfräsungen 20 nochmals Ausfräsungen 27 besitzen, die sich über die gesamte Länge des Massestegs 3 hinweg erstrecken und zwar auf beiden Seiten zu den Seitenteilen 1, 2 hin. Diese Ausfräsungen 27 bewirken, daß an der Unterseite des Massestegs 3 in unmittelbarer Nähe zum zu messenden Bauteil 30 ein guter Massekontakt zwischen Massesteg 3 und Seitenteilen 1, 2 vorhanden ist.

Trotz des Vorhandenseins von zwei Steckern, einem Durchgangsstück, einer Kontaktier-Einrichtung und den sonstigen Teilen der Meßfassung ergibt sich bei einer Meßfassung nach der Erfindung nur ein maxmimaler Return loss von 20 dB. Diese maximale Reflexionsdämpfung ist nur unwesentlich größer als die maximale Reflexionsdämpfung der beiden unmittelbar aneinander geflanschten Stecker alleine. Dies bedeutet, daß die Reflexionsdämpfung bei einer Meßfassung nach der Erfindung praktisch nur von der Qualität der Stecker beeinflußt wird. Dies bedeutet, daß eine Meßfassung nach der Erfindung praktisch beliebig gute Meßergebnisse liefern kann, wenn nur die Signalwege dies zulassen.

Eine Meßfassung nach der Erfindung ermöglicht eine enorm gute Isolation von 50 dB.

Die Meßfassung kann mit einem 50 Ohm-Durchgangsstück zur Untersuchung auf Störstellen bestückt werden. Die Güte der Meßfassung ist praktisch ausschließlich durch die Güte der Stecker begrenzt. Ist eine Meßfassung nach der Erfindung mit einem 50 Ohm-Durchgangsstück bestückt, so ergeben sich für die Meßfassung folgende Werte:
Ein-/Ausgangsreflexion mit Durchgangsstück:
S11, S22 kleiner als - 14 dB. Dies entspricht einer Ein-/Ausgangsreflexion von weniger - 20 dB pro Seite.
Die Summe aus Durchgangsreflexion und Durchgangsverlusten 521 ist kleiner als 0,4 dB. Die Isolation, das bedeutet die Überkopplung zwischen Eingang und Ausgang 512 ist kleiner - 60 dB. Dies bedeutet, daß die Isolation besser als die Auflösung des Meßsystems ist.

## Patentansprüche

1. Mikrowellen-Bauelemente-Meßfassung, die zur Einführung des zu messenden Bauelements (30) in die und zur Positionierung und Kontaktierung des Bauelements (30) in der Meßfassung eine Schiebe-Einrichtung (6 bis 9) umfaßt, die ein aus einem Schiebeteil (6) und einem Schieber (7) gebildetes Keilschiebesystem enthält, das eine Aufnahme (5) zum Einlegen und einen Anschlag (8) zum Positionieren und Kontaktieren des zu messenden Bauelements (30) aufweist, wobei der Anschlag (8) ein Widerlager für das Schiebeteil (6) bildet, und mit zwei Seitenteilen (1, 2) als Führungskörper für das Schiebeteil (6), **dadurch gekennzeichnet**, daß zwischen Aufnahme (5) und Schiebeteil (6) ein elastisches Massepolster (6.3) vorhanden ist, das einerseits zum elastischen Polstern des Bauelements (30) und andererseits als elektrische Masseverbindung zwischen der Aufnahme (5) und den beiden Seitenteilen (1, 2) bei geschlossener Meßfassung dient.

2. Meßfassung nach Anspruch 1, **gekennzeichnet durch** einen Massesteg (3).

3. Meßfassung nach Anspruch 2, **gekennzeichnet durch** eine Einrichtung zur Justierung des Massestegs (3).

## Claims

1. Microwave component test mounting which comprises, for the purpose of introducing the component (30) to be tested into the test mounting and for the purpose of positioning and contacting the component (30) in the test mounting, a sliding device (6 to 9) which contains a tapered slide system which is formed from a slide part (6) and a slider (7) and which has a receptacle (5) for the insertion of the component (30) to be tested and a stop (8) for positioning and contacting the latter, the stop (8) forming a thrust block for the slide part (6), and having two side parts (1, 2) as guide bodies for the slide part (6), characterized in that between receptacle (5) and slide part (6) there is present an elastic earth cushion (6.3) which, on the one hand, serves to elastically cushion the component (30) and, on the other hand, serves as electrical earth connection between the receptacle (5) and the two side parts (1, 2) when the test mounting is closed.

2. Test mounting according to Claim 1, characterized by an earth bar (3).

3. Test mounting according to Claim 2, characterized by a device for aligning the earth bar (3).

## Revendications

1. Équipage de mesure de composants à micro-ondes, qui comprend, pour l'introduction du composant à mesurer (30) dans l'équipage de mesure et pour le positionnement du composant (30) et l'établissement du contact avec ce composant dans l'équipage de mesure, un dispositif de translation (6 à 9), qui comporte un système coulissant en coin formé par une pièce coulissante (6) et un poussoir (7) et qui possède un logement (5) pour l'insertion du composant à mesurer (3) et une butée (8) pour le positionnement et l'établissement du contact avec le composant mesuré (3), la butée (8) formant appui pour la pièce coulissante (6), et comportant deux parties latérales (1, 2) formant corps de guidage pour la pièce coulissante (6), caractérisé par le fait qu'entre le logement (5) et la pièce coulissante (6) est prévue une masse de rembourrage élastique (6.3) qui, d'une part, sert à supporter élastiquement le composant (30) et, d'autre part, sert de liaison électrique à la masse entre le logement (5) et les deux parties latérales (1,2), lorsque l'équipage de mesure est fermé.

2. Équipage de mesure suivant la revendication 1, caractérisé par une barrette de masse (3).

3. Équipage de mesure suivant la revendication 2, caractérisé par un dispositif pour ajuster la barrette de masse (3).
